(19) Europäisches Patentamt
European Patent Office
Office européen des brevets

(11) Numéro de publication: **0 287 412 B1**

(12) # FASCICULE DE BREVET EUROPEEN

(45) Date de publication de fascicule du brevet: **08.06.94** (51) Int. Cl.[5]: **H05K 3/00**

(21) Numéro de dépôt: **88400669.3**

(22) Date de dépôt: **21.03.88**

(54) **Procédé microlithographique de réalisation de circuits utilisant des films organiques conducteurs, sensibles aux rayonnements électromagnétiques et aux particules chargées.**

(30) Priorité: **24.03.87 FR 8704075**

(43) Date de publication de la demande:
**19.10.88 Bulletin 88/42**

(45) Mention de la délivrance du brevet:
**08.06.94 Bulletin 94/23**

(84) Etats contractants désignés:
**DE GB NL**

(56) Documents cités:
**FR-A- 2 564 231**
**US-A- 4 312 935**
**US-A- 4 390 586**

**PHYSICAL REVIEW B, vol. 22, no. 12, 15 décembre 1980, pages 6035-6043; The Am. Physical Soc., GB; L. ZUPPIROLI et al.: "Irradiation effects in quasi-one-dimensional organic conductors: The evicence of a transverse fixed-range phono-assisted hopping"**

(73) Titulaire: **COMMISSARIAT A L'ENERGIE ATOMIOUE**
**31/33, rue de la Fédération**
**F-75015 Paris Cédex 15(FR)**

(72) Inventeur: **Barraud, André**
**4,rue des Closeaux**
**F-91440 Bures sur Yvette(FR)**
Inventeur: **Richard, Joel**
**2, rue Carnot**
**F-78190 Trappes(FR)**
Inventeur: **Vandevyver, Michel**
**14 rue du Général de Gaulle**
**F-92290 Chatenay Malabry(FR)**

(74) Mandataire: **Mongrédien, André et al**
**c/o BREVATOME**
**25, rue de Ponthieu**
**F-75008 Paris (FR)**

EP 0 287 412 B1

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

## Description

La présente invention a pour objet un procédé microlithographique de réalisation de zones conductrices de l'électricité utilisant un film organique conducteur, sensible aux rayonnements électromagnétiques et aux particules chargées.

Dans le domaine de la microélectronique, on utilise généralement des procédés microlithographiques pour former les circuits et les connexions électriques entre les microéléments actifs du circuit. Ceci est généralement obtenu par gravure d'une couche conductrice déposée préalablement sur le substrat. Ainsi, dans un procédé de ce type, on dépose tout d'abord la couche conductrice de l'électricité à graver qui est généralement constituée par un métal ou une couche de matériau semiconducteur inorganique ; et on dépose ensuite sur cette couche à graver une couche mince de "résist" sensible aux électrons ou aux rayonnements électromagnétiques. Cette couche de résist sert à former le dessin du circuit à graver et ce dessin est obtenu en irradiant la couche de résist au moyen d'électrons ou de rayonnements électromagnétiques, par exemple à travers un masque, et en développant ensuite l'image obtenue par dissolution sélective soit de la partie exposée aux rayonnements (résist positif) soit de la partie non exposée aux rayonnements (résist négatif). Ceci permet de mettre à nu certaines zones de la couche conductrice à graver qui peuvent être ensuite attaquées soit par un bain chimique, soit par un plasma, soit par bombardement d'ions réactifs. En fin d'opération, on élimine la couche de résist restante pour ne garder que les zones conductrices de l'électricité formées dans la couche de départ.

Dans ce procédé, l'obtention du dessin sur la couche conductrice est rendue possible grâce à la différence de solubilité des parties irradiées et non irradiées du résist, ce qui permet d'éliminer le résist aux endrois voulus et de graver la couche conductrice ainsi mise à nu.

Dans ces procédés, les matériaux utilisés comme résists sont généralement des résines organiques, isolantes, et de ce fait, des charges électrostatiques importantes se développent à leur surface pendant l'irradiation. On peut éviter cet inconvénient en déposant au-dessus de la couche de résist un film mince de métal ou de carbone, ou en utilisant un résist qui est lui-même conducteur de l'électricité comme il est décrit dans les brevets américains US-A 4 312 935, 4 312 936 et 4 338 392. Dans ces brevets, on utilise comme résist positif ou négatif un film conducteur organique d'un sel à transfert de charge. Dans le cas où on utilise ce sel comme résist positif, on irradie le film par des électrons ayant une énergie suffisante pour provoquer la volatilisation du film sur les parties exposées aux rayonnements. Dans le cas où on l'utilise comme résist négatif, on irradie le film au moyen d'électrons ayant une énergie suffisante pour réticuler les zones du film exposées à l'irradiation et on élimine ensuite les zones non exposées par dissolution dans un solvant.

Bien que dans ces derniers brevets on évite le dépôt d'un film mince métallique sur la couche de résist, il n'en reste pas moins que la définition des zones conductrices nécessite le dépôt d'au moins deux couches indépendantes, la couche conductrice à graver et la couche de résist, et que le procédé exige la séquence des nombreuses étapes successives décrites ci-dessus.

La présente invention a pour objet un procédé microlithographique qui permet d'éviter ces inconvénients en supprimant l'utilisation d'une couche indépendante de résist pour définir le dessin du circuit.

Le procédé, selon l'invention, de réalisation d'un circuit ou de connexions électriques sur un substrat comprenant une étape de définition de ce circuit ou de ces connexions par un procédé microlithographique utilisant une couche photosensible, constituée par une couche d' un composé organique, conducteur de l' électricité, susceptible d'être transformé en produit isolant par irradiation au moyen de particules chargées et/ou de rayonnements électromagnétiques, se caractérise en ce que l'on définit et forme, simultanément le circuit ou les connexions électriques sur le substrat en irradiant certains emplacements de la couche photosensible de composé organique au moyen de particules chargées et/ou de rayonnements électromagnétiques pour que les emplacements irradiés deviennent isolants et que l' on forme ainsi directement dans la couche de composé organique le circuit ou les connexions électriques aux endroits voulus.

Ainsi, dans le procédé de l'invention, la couche de composé organique sert à la fois de couche photosensible et de couche conductrice à graver. On peut de ce fait obtenir directement, par le seul effet de l'irradiation, les zones conductrices de l'électricité aux endroits voulus. On simplifie ainsi considérablement le procédé de réalisation de ces zones conductrices en supprimant de nombreuses étapes du procédé classique de microlithographie.

En effet, il n'est pas nécessaire de déposer successivement une couche conductrice et une couche photosensible, d'éliminer la couche photosensible en certains endroits pour graver la couche conductrice, de graver la couche conductrice et d'éliminer en fin d'opération le reste de la couche photosensible. De plus, ce procédé permet d'obtenir des zones conductrices qui ne sont pas en relief sur le substrat, ce qui simplifie dans de nombreux cas les opérations ultérieures de réalisation du composant électronique, par

exemple du circuit intégré.

Selon l'invention, on peut utiliser tout composé organique conducteur de l'électricité susceptible de devenir isolant après irradiation au moyen de particules chargées et/ou de rayonnements électromagnétiques. Ce composé peut être constitué en particulier par un complexe à transfert de charge, conducteur de l'électricité. La couche de composé organique peut être sous la forme d'un film mince obtenu par des procédés classiques ou encore sous la forme d'un film constitué d'au moins une couche monomoléculaire obtenue par exemple par la méthode de Langmuir-Blodgett. Dans le cas où l'on veut utiliser la méthode de Langmuir-Blodgett pour préparer le film, il est préférable que le composé organique, conducteur de l'électricité soit amphiphile.

A titre d'exemple de tels composés amphiphiles, on peut citer les complexes à transfert de charge répondant à la formule : $DA_xX_y$, dans laquelle D représente un groupe organique donneur d'électrons, A représente un groupe organique accepteur d'électrons, X représente un accepteur d'électrons non amphiphile choisi parmi les acides de Lewis, x est un nombre supérieur à 0, et y est égal à 0 ou est un nombre supérieur à 0, l'un au moins des groupes D et A étant amphiphile et comportant au moins un substituant hydrocarboné saturé ou insaturé d'au moins 12 atomes de carbone.

Généralement, x et y peuvent prendre des valeurs allant jusqu'à 20.

De préférence, le substituant hydrocarboné a de 14 à 30 atomes de carbone.

Dans la formule précitée, X représente avantageusement un acide de Lewis choisi parmi $I^-$, $I_3^-$ , $PF_6^-$ , $ClO_4^-$ , $BF_4^-$ , $ReO_4^-$ , $IO_4^-$ , $FSO_3^-$ , $AsF_6^-$ , $AsF_4^-$ , $BR^-$, $Cl^-$, et $MnCl_6^-$ .

De préférence, lorsque y est différent de 0, cet accepteur d'électrons non amphiphile est $I^-$ ou $I_3^-$ .

Selon un mode préféré de réalisation de l'invention, le groupe organique donneur d'électrons D est un groupe amphiphile comportant au moins un substituant hydrocarboné ayant au moins 12 atomes de carbone. Dans ce cas, D est avantageusement une base aliphatique, aromatique ou hétérocyclique comportant au moins un substituant hydrocarboné, saturé ou insaturé ayant au moins 12 atomes de carbone.

Parmi les bases aliphatiques susceptibles d'être utilisées, on peut citer les groupes ammonium quaternaire de formule :

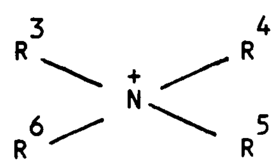

dans laquelle R3, R4, R5 et R6 qui peuvent être identiques ou différents, sont des radicaux alkyle ou des chaînes hydrocarbonées comportant éventuellement une ou plusieurs doubles et/ou triples liaisons, l'un au moins des groupes R3, R4, R5 et R6 ayant au moins 12 atomes de carbone.

Les bases aromatiques susceptibles d'être utilisées peuvent être avantageusement constituées par des groupes ammonium quaternaire dérivés de l'aniline ou de dérivés substitués de l'aniline.

Les bases hétérocycliques susceptibles d'être utilisées peuvent être constituées par des groupements ammonium quaternaire dérivés par des pyridines, des pipéridines, des bipyridines, des bipipéridines, des benzopyridines, par exemple des quinoléines, des isoquinoléines, des acridines, des phénazines et des phénanthrolines. Ces groupements peuvent répondre en particulier aux formules suivantes :

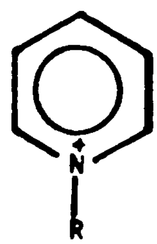

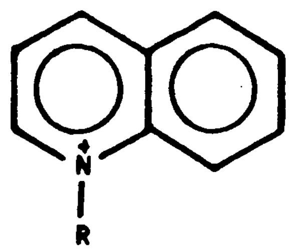

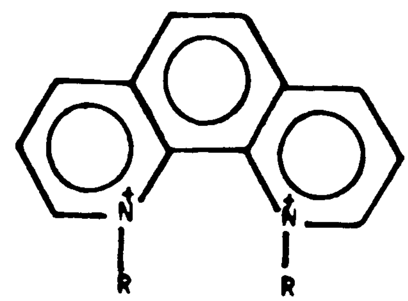

dans lesquelles le substituant R de l'atome d'azote peut être le radical hydrocarboné ayant plus de 12 atomes de carbone. Ce substituant R peut être également un atome d'hydrogène ou un radical alkyle inférieur ayant par exemple 1 à 4 atomes de carbone. Dans ce cas, le ou les noyau(x) benzénique(s) ou hétérocyclique(s) comporte(nt) au moins un autre substituant constitué par un radical hydrocarboné ayant plus de 12 atomes de carbone.

Ces noyaux peuvent également comporter un ou plusieurs autres substituants tels que des radicaux alkoxy, des radicaux alkyle, des radicaux COOR avec R représentant un radical alkyle, des atomes d'halogène, etc...

Le groupe D peut aussi représenter une base hétérocyclique comportant plusieurs hétéro-atomes de nature différente, par exemple des atomes d'azote et de soufre. A titre d'exemple de telles bases hétérocycliques, on peut citer les N-alkylbenzothiazoles et leurs dérivés substitués, et les N-alkylindoléniniumtriméthinecyanines et leurs dérivés substitués.

On précise que le terme "radical hydrocarboné saturé ou insaturé" désigne des radicaux formés d'atomes de carbone et d'hydrogène comportant éventuellement une ou plusieurs doubles et/ou triples liaisons. Ceux-ci peuvent être reliés au groupe accepteur d'électrons A et/ou au groupe donneur d'électrons D par une simple liaison, un atome d'oxygène ou un groupe -COO-.

Dans le complexe amphiphile de l'invention, le groupe organique accepteur d'électrons A peut être choisi parmi le tétracyanoéthylène (TCNE), l'hexacyanobutadiène (HCBD), le 1,2,4,5-tétracyanobenzène (TCNB), le 7,7,8,8-tétracyanoquinodiméthane (TCNQ) et ses dérivés substitués, le tétracyanodiquinodiméthane (TCNDQ), le benzotétracyanoquinodiméthane (benzo-TCNQ), le 2,3,5,6-tétrachloro-p-benzoquinone (CA), le trinitrobenzène (TNB), le tétranaphtoquinodiméthane (TNAP), le thiophénetétracyanoquinodiméthane (thiophène-TCNQ), le sélénophènetétracyanoquinodiméthane (sélénophène-TCNQ), et le tétracyanoquinoquinazolino quinazoline (TCQQ).

On peut également utiliser dans l'invention les dérivés substitués de ces groupes accepteurs d'électrons, par exemple des dérivés halogénés tels que les dérivés fluorés, des dérivés alcoxylés et des dérivés alkylés.

Des complexes de ce type sont décrits dans les brevets français FR-A-2 564 092 et FR-A-2 564 231.

On peut aussi utiliser dans l'invention d'autres composés amphiphiles, par exemple des complexes ou des sels de tétracyanoquinodiméthane ou de l'un de ses dérivés, par exemple de ses dérivés fluorés, alcoxylés ou alkylés.

On peut aussi utiliser dans l'invention des composés organiques constitués par des sels à transfert de charge tels que les sels halogénés de tétrathiafulvalène et de ses dérivés alkylés.

On peut encore utiliser dans l'invention des complexes à transfert de charge de tétracyanoquinodiméthane et de composés tels que le tétrathiafulvalène.

L'utilisation de composés amphiphiles sous la forme de films de Langmuir-Blodgett constitués d'une ou plusieurs couches monomoléculaires superposées est particulièrement avantageuse en raison de la grande uniformité et de la grande homogénéité intrinsèque de ces films qu'il convient de ne pas perturber par un traitement de révélation. Ces films restent en effet homogènes et sans trou pour des épaisseurs inférieures à 50 nm.

Aussi, étant donné que l'épaisseur de la couche sensible et conductrice peut être très faible, l'énergie du rayonnement ou des particules chargées nécessaire pour transformer le film en produit isolant peut être basse, ce qui conduit à un tracé plus fin des motifs du fait du moindre élargissement par diffusion latérale, et permet ainsi d'obtenir une meilleure résolution spatiale.

Pour mettre en oeuvre le procédé de l'invention, on commence tout d'abord par déposer sur un substrat isolant la couche de composé oganique conducteur de l'électricité. Ceci peut être effectué par des méthodes classiques, par exemple par enduction du substrat au moyen d'une solution du composé organique, par sédimentation ou par la méthode de Langmuir-Blodgett.

De préférence, lorsque le composé organique est amphiphile, on réalise le dépôt de la couche en formant sur le substrat une ou plusieurs couches monomoléculaires par la méthode de Langmuir-Blodgett décrite dans Journal of Am. Chem. Soc., 57, 1935, pp. 1007-1010.

Dans certains cas, pour favoriser l'adhérence de la couche de composé organique sur le substrat, on dépose tout d'abord sur ce substrat, une sous-couche d'adhérence qui peut être constituée par exemple par un acide gras comme l'acide béhénique ou l'acide ω-tricosénoïque, une porphyrine ou une phtalocyanine. Le dépôt de cette sous-couche d'adhérence peut être réalisé comme précédemment, par exemple par la méthode de Langmuir-Blodgett lorsque le composé utilisé pour la réalisation de cette couche est un composé amphiphile.

Pour transformer ensuite, selon l'invention, certaines zones de la couche de composé organique conducteur de l'électricité en produit isolant, on soumet les zones de la couche à une irradiation au moyen

de particules chargées, par exemple d'ions ou d'électrons, ou au moyen d'un rayonnement électromagnétique tel que les rayons X, les rayons ultraviolets, les rayons gamma, et le rayonnement cohérent provenant d'un laser. L'énergie et la dose de rayonnement ou d'irradiation appliquées sont choisies de façon à simplement transformer le film en produit isolant sans dégrader celui-ci, par exemple par évaporation comme c'est le cas dans le procédé décrit dans le brevet américain US-A-4 312 936. La dose d'irradiation nécessaire dépend en particulier des caractéristiques du faisceau, par exemple de son énergie, ainsi que des molécules utilisées pour former la couche et de l'épaisseur de cette couche. Le contraste, c'est-à-dire la pente au point d'inflexion de la courbe d'exposition $d\sigma/d\log D$ où $\sigma$ est la conductivité du film et D est la dose appliquée, dépend également de la molécule utilisée pour la réalisation de la couche.

D'autres caractéristiques et avantages de l'invention apparaîtront mieux à la lecture des exemples suivants donnés bien entendu à titre illustratif et non limitatif, en référence à la figure unique annexée qui représente un jeu de thermistances fabriquées par le procédé de l'invention.

EXEMPLE 1 : Utilisation d'une couche conductrice de tétrathiafulvalène-(tétracyanoquinodiméthane)$_{1,5}$ (TTF-(TCNQ)$_{1,5}$)

On prépare tout d'abord le complexe TTF-(TCNQ)$_{1,5}$ par combinaison du donneur et de l'accepteur ou par métathèse des sels respectifs.

On dépose ensuite sur un substrat d'alumine un film mince du complexe TTF-(TCNQ)$_{1,5}$ par sédimentation à partir d'une solution contenant $10^{-3}$ mol/l de ce complexe dans un mélange chloroforme-acétonitrile à 8 volumes de chloroforme pour deux volumes d'acétonitrile.

On obtient ainsi un film de TTF-(TCNQ)$_{1,5}$ ayant une épaisseur de 300 nm, qui présente une conductivité de 1S.cm$^{-1}$.

On soumet alors certaines parties du film à une irradiation au moyen d'un faisceau électronique programmé selon le dessin que l'on veut obtenir en utilisant une dose d'irradiation de 100 $\mu$C.cm$^{-2}$ à 5 keV.

On transforme ainsi les parties irradiées du film. Après cette irradiation, la conductivité du film sur les parties irradiées est diminuée par un facteur supérieur à 100 et on obtient ainsi directement le circuit conducteur ayant le tracé voulu.

EXEMPLE 2 : Utilisation d'une couche de docosylpyridinium tétracyanoquinodiméthane (DCP-TCNQ)

Dans cet exemple, on dépose tout d'abord sur le substrat réalisé en fluorine une sous-couche d'adhérence constituée par trois couches monomoléculaires superposées d'acide $\omega$-tricosénoïque. Dans ce but, on prépare une solution de $CHCl_3$ contenant $10^{-3}$ mol.l$^{-1}$ d'acide $\omega$-tricosénoïque et on la disperse sur la surface de l'eau d'une cuve de Langmuir. On comprime ensuite la couche à 32 mN.m$^{-1}$ et on la dépose sur le substrat isolant. On répète ensuite ces opérations pour déposer sur le substrat en fluorine trois couches monomoléculaires d'acide $\omega$-tricosénoïque.

On prépare ensuite le complexe amphiphile (DCP-TCNQ) par métathèse à partir de l'iodure de docosylpyridinium et du sel de lithium de TCNQ.

On lave le complexe obtenu et on le recristallise. La poudre bleue du complexe ainsi obtenue n'est pas conductrice. On solubilise cette poudre dans un mélange de chloroforme et d'alcool à 5% en volume d'alcool, pour obtenir une solution contenant 5.10$^{-4}$ mol.l$^{-1}$ du complexe, et on forme sur la surface d'une cuve de Langmuir remplie d'eau distillée une couche monomoléculaire que l'on comprime à une pression de 36 mN.m$^{-1}$. On transfère ensuite cette couche sur le substrat en $CaF_2$ qui a été recouvert au préalable des trois couches monomoléculaires d'acide $\omega$-tricosénoïque comme on l'a vu précédemment.

On recommence ces opérations pour obtenir un film formé de 12 couches monomoléculaires superposées de DCP-TCNQ sur le substrat de fluorine. Ce film est isolant, mais on fait diffuser de l'iode pendant 15 s à 20°C, ce qui provoque une réorganisation des couches et rend le film conducteur, la résistivité du film est de 20 Ω.cm à 20°C.

On soumet alors le film à l'action d'un faisceau d'électrons programmé selon le dessin que l'on veut obtenir pour rendre le film isolant aux endroits voulus. La dose d'irradiation $D_{50}$ nécessaire pour diviser la conductivité $\sigma$ du film par 2 est de 30 $\mu$C.cm$^{-2}$ à 3 keV et le contraste obtenu $\gamma$ (qui est défini par la pente au point d'inflexion de la courbe d'exposition, c'est-à-dire de la courbe $d\sigma/d\log D$ avec D représentant la dose), est compris entre 0,8 et 0,9.

EXEMPLE 3 : Utilisation d'un film constitué d'octadécylpyridinium tétracyanoquinodiméthane (ODP-TCNQ)

On synthétise tout d'abord le complexe à transfert de charge ODP-TCNQ en faisant réagir à chaud dans une solution alcoolique, l'iodure d'octadécylpyridinium avec le sel de lithium du tétracyanoquinodiméthane. On obtient ainsi, après refroidissement, une poudre du complexe que l'on lave et que l'on recristallise. Ce complexe est ensuite redissous dans l'acétonitrile avec un équivalent de TCNQ. Un complexe noir cristallise à froid. Il est conducteur de l'électricité.

On prépare alors une solution contenant $5.10^{-4}$ $mol.l^{-1}$ de ce complexe dans du chloroforme et l'on disperse cette solution sur la surface de l'eau d'une cuve de Langmuir. On forme ainsi une couche monomoléculaire que l'on comprime à une pression de 26 $mN.m^{-1}$ et on la transfère alors sur un substrat isolant en $CaF_2$ par la méthode de Langmuir Blodgett.

On recommence plusieurs fois ces opérations afin d'obtenir un film formé de 6 couches monomoléculaies superposées sur le substrat de fluorine. La résistivité du film ainsi obtenu est de 50 Ω.cm.

On soumet alors le film à un faisceau d'électrons ayant une énergie de 3 keV en utilisant un masque pour définir le dessin. Ce film devient ainsi progressivement isolant sur les parties non masquées. La dose $D_{50}$ nécessaire pour diviser par 2 la conductivité du film est de 5 $\mu C.cm^{-2}$ et le contraste est égal à 2. On peut ainsi obtenir des stries isolantes de 10 m de large en irradiant le film par un faisceau d'électrons à une dose de 50 $\mu C.cm^{-2}$.

EXEMPLE 4 : Utilisation d'un film d'octadécyltétracyanoquinodiméthane, tétraméthyl tétrathiafulvalène (ODTCNQ-TMTTF).

On synthétise tout d'abord le sel à transfert de charge ODTCNQ-TMTTF en faisant réagir par combinaison directe du donneur et de l'accepteur.

On prépare ensuite une solution contenant $5.10^{-4}$ $mol.l^{-1}$ de ce complexe dans du $CHCl_3$ et l'on disperse cette solution sur la surface de l'eau d'une cuve de Langmuir. On forme ainsi une couche monomoléculaire que l'on comprime à une pression de 25 $mN.m^{-1}$ et on la transfère alors sur un substrat isolant en silice fondue par la méthode de Langmuir Blodgett. On recommence plusieurs fois l'opération afin d'obtenir un film comportant 10 couches monomoléculaires superposées.

Le film obtenu est conducteur de l'électricité et présente une résistivité de 1 Ω.cm. On le soumet alors à un faisceau d'électrons programmé ayant une énergie de 5 keV de façon à exposer au faisceau des bandes parallèles du film. Avec une dose de 100 $\mu C.cm^{-2}$, on transforme le film en zones isolantes indépendantes séparées par des bandes conductrices.

EXEMPLE 5 :

On suit le même mode opératoire que dans l'exemple 1, mais au lieu de soumettre le film de TTF-$(TCNQ)_{1,5}$ à une irradiation au moyen d'un faisceau d'électrons, on le soumet à une irradiation par des rayonnements ultraviolets, dans l'air, pendant 10 min, en utilisant une lampe à mercure de 1 kW à 253,65nm et un masque métallique placé contre le film. Après irradiation, le film présente des parties isolantes corrrespondant aux zones irradiées.

EXEMPLE 6 :

On répète le mode opératoire de l'exemple 2, mais on réalise l'irradiation du film de DCP-TCNQ dans les mêmes conditions que celles de l'exemple 5. On obtient de la même façon des parties isolantes sur les zones irradiées.

EXEMPLE 7 :

On répète le mode opératoire de l'exemple 3, mais on réalise l'irradiation du film de ODP-TCNQ dans les conditions de l'exemple 5. On obtient comme précédemment des parties isolantes sur les zones irradiées.

EXEMPLE 8 :

On répète le mode opératoire de l'exemple 4 pour préparer un film conducteur comportant 10 couches monomoléculaires de ODTCNQ-TMTTF, et on soumet ensuite ce film à une irradiation dans les conditions

de l'exemple 5. On obtient ainsi des parties isolantes sur les zones irradiées.

EXEMPLE 9 :

On répète le mode opératoire des exemples 1 à 4 pour préparer des films conducteurs, et on les soumet à une irradiation par la lumière d'un laser à argon de 25 W, accordé sur la raie à 514,5 nm en répartissant la lumière sur 5 $mm^2$ et en l'envoyant sur le film à travers un masque métallique donnant le dessin du circuit. On obtient le circuit désiré, délimité par des zones isolantes, après moins d'une minute d'irradiation.

EXEMPLE 10 :

On répète le mode opératoire des exemples 1 à 4 pour préparer des films conducteurs de l'électricité. On les soumet ensuite à une irradiation au moyen de rayons X correspondant à la raie $K_\alpha$ du cuivre, en utilisant un masque en or correspondant au dessin du circuit.

On obtient le circuit désiré sur tous les films en utilisant des doses d'irradiation allant de 100 $mJ.cm^{-2}$ à 1 $J.cm^{-2}$.

EXEMPLE 11 :

On répète le mode opératoire de l'exemple 3 pour préparer un film organique conducteur formé de 6 couches monomoléculaires du complexe ODP-TCNQ.

On soumet ensuite le film à un faisceau d'ions $Ar^+$ d'énergie 50 keV à travers un masque fait de bandes parallèles de 0,5 mm de large. Après avoir reçu une dose de 50 $\mu C.\ cm^{-2}$, le film est transformé en bandes isolantes séparées par des bandes conductrices.

EXEMPLE 12 : Réalisation de composants électroniques.

Dans cet exemple, on prépare un jeu de thermistances à faible inertie thermique, constituée de films minces, pour mesures locales de variation de température créée par un rayonnement de lumière visible.

On synthétise tout d'abord le complexe à transfert de charge ODP-TCNQ en suivant le même mode opératoire que dans l'exemple 3. On dépose ensuite un film constitué de 50 couches monomoléculaires de ODP-TCNQ superposées sur un substrat de silice fondue de 10x5x2 $mm^3$, dont on souhaite connaître les variations de température en un point, en utilisant le même mode opératoire que dans l'exemple 3. On soumet alors le film à un faisceau d'électrons ayant une énergie de 3 keV, programmé de façon à obtenir le dessin représenté sur la figure annexée en utilisant des doses totales d'irradiation différentes sur certaines zones du substrat de silice recouvert du film.

Sur la figure annexée, on voit que des zones 1, 2 et 3 ont été délimitées sur le film lors de l'irradiation. Les zones 1 représentées en blanc sont les zones qui n'ont pas été soumises à l'irradiation, les zones 2 représentées en traits hachurés sont les zones qui ont été irradiées à une dose totale de 5 $\mu C/cm^2$ et les zones 3 représentées en pointillés sont les zones irradiées à une dose totale de 50 $\mu C/cm^2$.

Ainsi, les zones non irradiées 1 sont restées conductrices de l'électricité, les zones 2 ont une conductivité électrique divisée par 2 et les zones 3 sont isolantes.

On réalise ensuite des contacts en or d'une épaisseur de 1000 Angströms par évaporation d'or, aux deux extrémités des thermistances sur les zones 4 (délimitées par des traits mixtes). On obtient ainsi un jeu de thermistances montées en parallèle.

On détermine alors la résistance R du jeu de thermistances en fonction de la température T, pour des températures allant de 15 °C à 50 °C en disposant l'ensemble dans une enceinte thermostatée et en relevant la résistance à l'aide d'un électromètre Keithley 617 A. Les valeurs obtenues sont données dans le tableau 1 ci-dessous :

TABLEAU 1

| T(°C) | R(MΩ) |
|---|---|
| 15 | 5,98 |
| 18 | 5,61 |
| 21 | 5,26 |
| 24 | 4,95 |
| 27 | 4,66 |
| 30 | 4,39 |
| 33 | 4,14 |
| 36 | 3,91 |
| 39 | 3,70 |
| 42 | 3,50 |
| 45 | 3,32 |
| 48 | 3,15 |
| 50 | 3,04 |

On place ensuite l'ensemble des thermistances dans le faisceau de lumière d'un spectrophotomètre visible Cary 2300, de telle sorte que le faisceau tombe sur les zones 2 qui avaient été précédemment irradiées à la dose de 5 $\mu C/cm^2$.

Dans ces conditions, des variations de température de 0,5 °C de la lame de silice sont détectées.

EXEMPLE 13 :

Dans cet exemple, on réalise un jeu de thermistances à faible inertie thermique, en films minces, destiné à un capteur de température dans un processus de régulation thermique. On répète le mode opératoire de l'exemple 12 mais seules les zones 3 du substrat de silice sont irradiées à la dose de 50 $\mu C/cm^2$. Les zones 2 ont donc la conductivité initiale du film de ODP-TCNQ.

On détermine alors comme dans l'exemple 12, la résistance R du jeu de thermistances en fonction de la température T, pour des températures allant de 5 °C à 26 °C en utilisant une enceinte thermostatée et un électromètre Keithley 617 A. Les résultats obtenus sont donnés dans le tableau 2 ci-dessous.

TABLEAU 2

| T(°C) | R (MΩ) |
|---|---|
| 5 | 4,49 |
| 8 | 4,19 |
| 11 | 3,91 |
| 14 | 3,66 |
| 17 | 3,43 |
| 20 | 3,22 |
| 23 | 3,03 |
| 26 | 2,85 |

On utilise ensuite ce jeu de thermistances de la façon suivante.

On colle le substrat de silice fondue sur la paroi intérieure d'une enceinte en cuivre, ayant des dimensions de 10x10x10 $cm^3$, dont on souhaite réguler la température à 15 °C ± 0,7 °C au moyen d'une circulation d'air froid et d'une résistance chauffante de 10 Ω et de 50 W. Le jeu de thermistances qui est utilisé comme capteur de température, est inséré dans la chaîne de réactions de la régulation de température et il est alimenté par un courant électrique constant. Les variations de résistance des thermistances sont ainsi transformées en variations de tension aux bornes de celles-ci. On peut ainsi réguler la température de l'enceinte à 15 °C avec une précision de ± 0,5 °C.

## Revendications

1. Procédé de réalisation d'un circuit ou de connexions électriques sur un substrat comprenant une étape de définition de ce circuit ou de ces connexions par un procédé microlithographique utilisant une couche photosensible, constituée par une couche d'un composé organique, conducteur de l'électricité, susceptible d'être transformé en produit isolant par irradiation au moyen de particules chargées et/ou de rayonnements électromagnétiques, caractérisé en ce que l'on définit et forme simultanément le circuit ou les connexions électriques sur le substrat en irradiant certains emplacements de la couche photosensible de composé organique au moyen de particules chargées et/ou de rayonnements électromagnétiques pour que les emplacements irradiés deviennent isolants et que l'on forme ainsi directement dans la couche de composé organique le circuit ou les connexions électriques aux endroits voulus.

2. Procédé selon la revendication 1, caractérisé en ce que la couche de composé organique est constituée par au moins une couche monomoléculaire d'un composé organique, conducteur de l'électricité et amphiphile.

3. Procédé selon la revendication 2, caractérisé en ce que la ou les couche(s) monomoléculaire(s) du composé organique, conducteur de l'électricité et amphiphile sont déposées sur le substrat par la méthode de Langmuir-Blodgett.

4. Procédé selon l'une quelconque des revendications 1 et 3, caractérisé en ce que le composé organique est un complexe à transfert de charge.

5. Procédé selon la revendication 4, caractérisé en ce que le complexe organique à transfert de charge amphiphile répond à la formule $DA_xX_y$, dans laquelle D représente un groupe organique donneur d'électrons, A représente un groupe organique accepteur d'électrons, X représente un accepteur d'électrons non amphiphile choisi parmi les acides de Lewis, x est un nombre supérieur à 0, et y est égal à 0 ou est un nombre supérieur à 0, l'un au moins des groupes D et A étant amphiphile et comportant au moins un substituant hydrocarboné saturé ou insaturé d'au moins 12 atomes de carbone.

6. Procédé selon la revendication 1, caractérisé en ce que le composé organique est un sel ou un complexe de tétracyanoquinodiméthane ou de l'un de ses dérivés.

7. Procédé selon la revendication 1, caractérisé en ce que le composé organique est te tétrathiafulvalène-(tétracyanoquinodiméthane)$_{1,5}$.

8. Procédé selon l'une quelconque des revendications 1 à 3, caractérrisé en ce que le composé organique est un complexe ou un sel à transfert de charge, conducteur de l'électricité, choisi dans le groupe comprenant le docosylpyridiniumtétracyanoquinodiméthane, l'octadécylpyridiniumtétracyanoquinodiméthane et l'octadécyltétracyanoquinodiméthane-tétraméthyl-tétrathiafulvalène.

9. Procédé selon l'une quelconque des revendications 1 à 8, caractérisé en ce que les particules chargées sont des ions ou des électrons.

10. Procédé selon l'une quelconque des revendications 1 à 8, caractérisé en ce que les rayonnements électromagnétiques sont choisis dans le groupe comprenant les rayons X, les rayonnements ultraviolets et le rayonnement laser.

## Claims

1. Process for producing a circuit or electrical connections on a substrate incorporating a stage of defining said circuit or said connections by a microlithographic process using a photosensitive layer, constituted by a layer of an organic compound which conducts electricity and which can be transformed into an insulating product by irradiation by means of charged particles and/or electromagnetic rays, characterized in that definition and forming take place simultaneously of the circuit or electrical connections on the substrate by irradiating certain locations of the organic compound photosensitive layer by means of charged particles and/or electromagnetic rays, so that the irradiated locations become insulating and in that in this way formation directly takes place in the organic compound layer of the circuit or the electrical connections at the desired locations.

2. Process according to claim 1, characterized in that the organic compound coating is constituted by at least one monomolecular coating of an amphiphilic, electricity conducting, organic compound.

3. Process according to claim 2, characterized in that the monomolecular coating or coatings of the amphiphilic, electricity conducting, organic compound are deposited on the substrate by the Langmuir-Blodgett method.

4. Process according to either of the claims 1 and 2, characterized in that the organic compound is a charge transfer complex.

5. Process according to claim 4, characterized in that the organic, amphiphilic charge transfer complex is in accordance with the formula $DA_xX_y$, in which D represents an organic electron donor group, A represents an organic electron acceptor group, X represents a non-amphiphilic electron acceptor chosen from among the Lewis acids, x is a number greater than zero and y is equal to zero or is a number greater than zero, at least one of the groups D and A being amphiphilic and having at least one saturated or unsaturated hydrocarbon substituent with at least 12 carbon atoms.

6. Process according to claim 1, characterized in that the organic compound is a salt or a complex of tetracyanoquinodimethane or of one of its derivatives.

7. Process according to claim 1, characterized in that the organic compound is tetrathiafulvalene-(tetracyanoquinodimethane)$_{1.5}$.

8. Process according to either of the claims 1 and 2, characterized in that the organic compound is an electricity conducting charge transfer complex or salt chosen from the group including docosyl-pyridiniumtetracyanoquinodimethane, octadecylpyridiniumtetracyanoquinodimethane and octadecyl-tetracyanoquinodimethane-tetramethyl-tetrathiafulvalene.

9. Process according to claim 1, characterized in that the charged particles are ions or electrons.

10. Process according to claim 1, characterized in that the electromagnetic radiation is chosen from the group including X-rays, ultraviolet radiation and laser radiation.

## Patentansprüche

1. Verfahren zur Herstellung einer Schaltung oder von elektrischen Anschlüssen auf einem Substrat, umfassend einen Schritt zur Definition dieser Schaltung oder dieser Anschlüsse durch ein mikrolithographisches Verfahren, das eine photosensible Schicht verwendet, gebildet durch eine Schicht einer organischen Verbindung, elektrisch leitend, geeignet, überführt zu werden in ein isolierendes Produkt durch Bestrahlung mittels geladener Teilchen und/oder elektromagnetischer Strahlung,
dadurch **gekennzeichnet**,
daß man die Schaltung oder die elektrischen Anschlüsse auf dem Substrat simultan definiert und formt, indem bestimmte Bereiche der photosensiblen Schicht aus der organischen Verbindung bestrahlt werden mittels geladener Teilchen und/oder elektromagnetischer Strahlung, damit die bestrahlten Bereiche Isolatoren werden und man somit direkt in der Schicht der organischen Verbindung die Schaltung oder die elektrischen Anschlüsse an den gewünschten Stellen bildet.

2. Verfahren nach Anspruch 1, dadurch gekennzeichnet, daß die Schicht aus organischer Verbindung gebildet wird durch wenigstens eine monomolekulare Schicht einer organischen Verbindung, elektrisch leitend und amphiphil.

3. Verfahren nach Anspruch 2, dadurch gekennzeichnet, daß die monomolekulare(n) Schicht(en) aus organischer Verbindung, elektrisch leitend und amphiphil, abgeschieden werden auf dem Substrat mittels des Langmuir-Blodgett-Verfahrens.

4. Verfahren nach einem der Ansprüche 1 und 3, dadurch gekennzeichnet, daß die organische Verbindung ein Ladungsübertragungskomplex ist.

5. Verfahren nach Anspruch 4, dadurch gekennzeichnet, daß der amphiphile organische Ladungsübertragungskomplex der Formel $DA_xX_y$ entspricht, wobei D eine organische Elektronendonatorgruppe darstellt, A eine organische Elektronenakzeptorgruppe darstellt, X einen nichtamphphilen Elektronenakzeptor darstellt, ausgewählt unter den Lewis-Säuren, x eine Zahl größer als 0 ist und y gleich 0 ist oder eine Zahl größer als 0 ist, wobei wenigstens eine der Gruppen D und A amphiphile ist und wenigstens einen gesättigten oder nichtgesättigten, Kohlenwasserstoff-Substituenten enthält, mit wenistens 12 Kohlenstoffatomen.

6. Verfahren nach Anspruch 1, dadurch gekennzeichnet, daß die organische Verbindung ein Salz ist oder ein Tetracyanochinodimethan-Komplex oder eines seiner Derivate.

7. Verfahren nach Anspruch 1, dadurch gekennzeichnet, daß die organische Verbindung das Tetrathiafulvalen-(Tetracyanochinodimethan) ist.

8. Verfahren nach einem der Ansprüche 1 bis 3, dadurch gekennzeichnet, daß die organische Verbindung ein Komplex oder ein Salz mit Ladungsübertragung ist, elektrisch leitend, gewählt aus der Gruppe, die das Docosylpyridiniumtetracyanochinodimethan, das Octadecylpyridiniumtetracyanochinodimethan und das Octadecyltetracyanochinodimethan-Tetramethyl-Tetrathia-Fulvalen umfaßt.

9. Verfahren nach einem der Ansprüche 1 bis 8, dadurch gekennzeichnet, daß die geladenen Teilchen Ionen oder Elektronen sind.

10. Verfahren nach einem der Ansprüche 1 bis 8, dadurch gekennzeichnet, daß die elektromagnetische Strahlungen gewählt werden innerhalb der Gruppe, die die X- bzw. Röntgen-Strahlen, die ultravioletten Strahlen und die Laserstrahlen umfaßt.

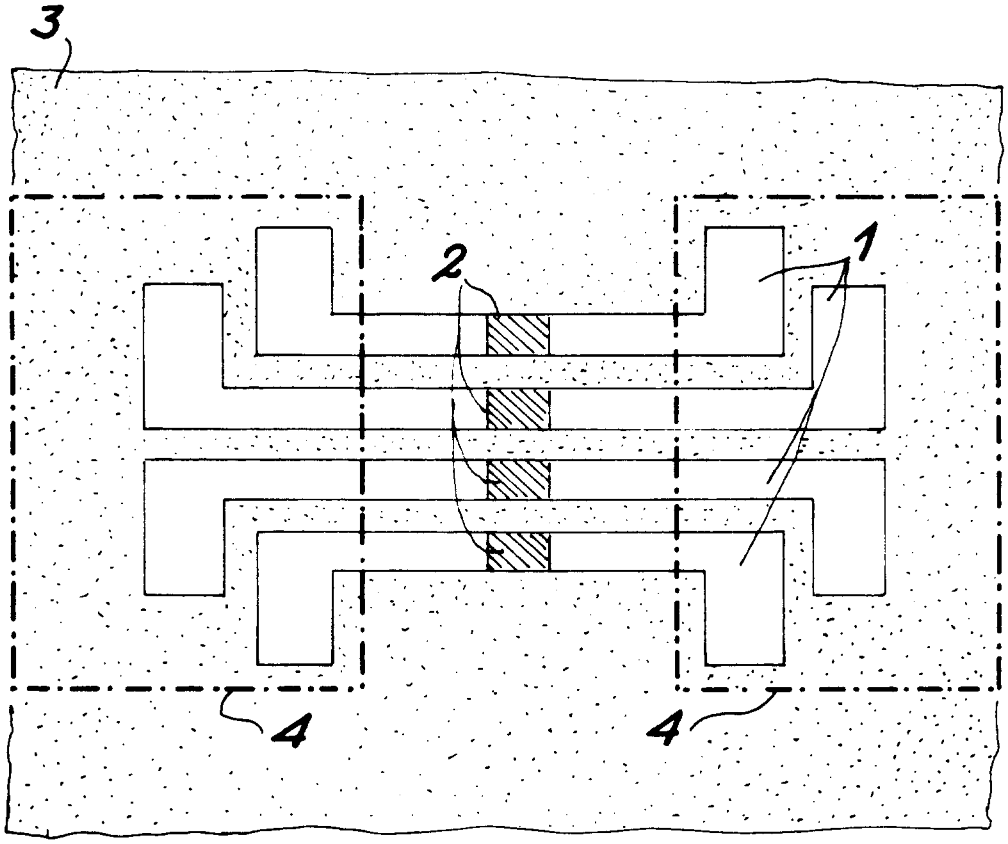
3
2
1
4
4